(19) Europäisches Patentamt
European Patent Office
Office européen des brevets

(11) **EP 1 155 442 B1**

(12) **FASCICULE DE BREVET EUROPEEN**

(45) Date de publication et mention
de la délivrance du brevet:
**17.12.2008 Bulletin 2008/51**

(51) Int Cl.:
*H01L 21/20* (2006.01)          *H01L 21/18* (2006.01)
*H01L 21/762* (2006.01)          *B81B 3/00* (2006.01)

(21) Numéro de dépôt: **00903763.1**

(22) Date de dépôt: **09.02.2000**

(86) Numéro de dépôt international:
**PCT/FR2000/000308**

(87) Numéro de publication internationale:
**WO 2000/048238 (17.08.2000 Gazette 2000/33)**

(54) **PROCEDE DE REALISATION D'UNE STRUCTURE MULTICOUCHE A CONTRAINTES INTERNES CONTROLEES**

VERFAHREN ZUR HERSTELLUNG EINER MEHRSCHICHTIGEN STRUKTUR MIT KONTROLLIERTEN EIGENSPANNUNGEN

METHOD FOR FABRICATING A MULTILAYER STRUCTURE WITH CONTROLLED INTERNAL STRESSES

(84) Etats contractants désignés:
**DE FR GB IT NL**

(30) Priorité: **10.02.1999 FR 9901558**

(43) Date de publication de la demande:
**21.11.2001 Bulletin 2001/47**

(73) Titulaire: **COMMISSARIAT A L'ENERGIE ATOMIQUE**
**75015 Paris (FR)**

(72) Inventeurs:
• **MORICEAU, Hubert**
**F-38120 Saint-Egreve (FR)**
• **RAYSSAC, Olivier**
**F-38000 Grenoble (FR)**
• **CARTIER, Anne-Marie**
**Le Genevrey,**
**38450 Vif (FR)**

• **ASPAR, Bernard**
**F-38140 Rives (FR)**

(74) Mandataire: **Weber, Etienne Nicolas et al**
**Brevatome**
**3, rue du Docteur Lancereaux**
**75008 Paris (FR)**

(56) Documents cités:
EP-A- 0 410 679          US-A- 5 261 999
US-A- 5 362 667          US-A- 5 373 184
US-A- 5 728 623          US-A- 5 753 134

• **PATENT ABSTRACTS OF JAPAN vol. 18, no. 213 (E-1538), 15 avril 1994 (1994-04-15) & JP 06 013593 A (SUGIYAMA ET AL), 21 janvier 1994 (1994-01-21)**

**Description**

Domaine technique

La présente invention concerne une structure multicouche obtenue par adhésion ou adhérence, en particulier moléculaire, caractérisée par des contraintes internes contrôlées, et un procédé de réalisation d'une telle structure.

On entend par structure multicouche à contraintes contrôlées, une structure comprenant au moins deux couches, dites couches principales, présentant entre elles des contraintes en tension ou en compression. Ces contraintes sont déterminées et contrôlées en fonction de la destination de la structure.

L'invention trouve des applications dans les domaines de la microélectronique, comme substrat ou comme raidisseur, mais aussi dans les domaines de la micromécanique pour la fabrication de capteurs à membrane, par exemple.

Etat de la technique antérieure

Parmi les structures multicouches assemblées par des techniques d'adhésion moléculaire (wafer bonding), on peut citer, à tire d'exemple, les structures SOI (silicium sur isolant/silicon on insulator). De façon typique une structure multicouche SOI comporte une couche épaisse de silicium servant de support, une couche isolante en oxyde de silicium et une couche superficielle de silicium mince, dont l'épaisseur est comprise entre quelques dizaines de nanomètres à quelques dizaine de micromètres.

La fabrication des structures SOI comporte généralement la mise en contact par adhésion moléculaire de deux plaquettes de silicium dont l'une au moins est recouverte par une couche superficielle d'oxyde de silicium.

Après la mise en contact, les plaquettes subissent généralement un traitement thermique sous atmosphère contrôlée. La fonction de ce traitement thermique est d'améliorer le contact intime et par conséquent l'adhérence des plaquettes.

Lors du traitement thermique, les matériaux en présence, en particulier le silicium en contact avec l'oxyde de silicium, sont susceptibles de s'imposer mutuellement des contraintes. Les contraintes sont liées en particulier aux différences de coefficient de dilatation thermique, $\Delta l/l$ des matériaux en contact. Ces différences de coefficients de dilatation des matériaux des surfaces en contact sont également la source de contraintes lors du refroidissement des structures intimement liées.

De façon plus générale, il est également connu, qu'un film de $SiO_2$ sur une plaquette de silicium, lorsqu'il est réalisé à certaines températures, a pour effet d'induire une déformation de la plaquette lors de son refroidissement. La déformation relative sous l'effet de la chaleur, notée $\Delta l/l$, est de l'ordre de $2,6.10^{-6}$/K pour le silicium, et de l'ordre de $5.10^{-7}$/K pour l'oxyde de $SiO_2$ réalisé par oxydation thermique du silicium.

Lorsque le film d'oxyde est formé sur une face de la plaquette de silicium, la mesure de la flèche au centre de la plaquette permet de quantifier la déformation due aux contraintes. Du fait de la différence des coefficients de dilatation thermique, une diminution de la température génère une compression du film d'oxyde sur la plaquette de silicium. Cette compression se traduit par une convexité de la plaquette. La convexité est d'autant plus marquée que le film d'oxyde est épais, et peut entraîner une modification de la morphologie de surface.

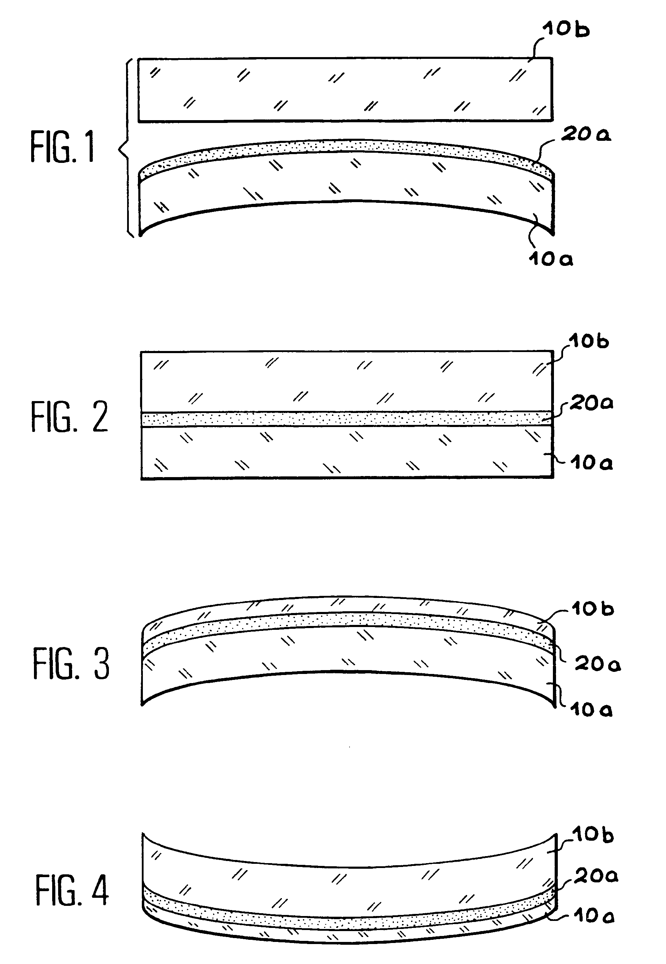

Les figures 1 à 4 annexées permettent d'illustrer les contraintes engendrées dans des structures SOI réalisées par des procédés classiques par adhésion moléculaire.

La figure 1 montre une première couche principale 10a, ou support, sous la forme d'une plaque de silicium présentant à sa surface une couche mince d'oxyde thermique 20a.

On observe que l'ensemble formé par la première couche principale de silicium 10a et la couche superficielle d'oxyde 20a est cintré. La surface de la couche d'oxyde 20a est convexe.

La référence 10b désigne une plaquette de silicium formant une deuxième couche principale dont les faces parallèles sont planes. Dans l'exemple illustré, les couches principales 10a et 10b présentent initialement des épaisseurs du même ordre de grandeur.

La figure 2 montre la structure obtenue par assemblage des couches principales 10a et 10b. Ces couches sont reliées par la couche d'oxyde 20a. L'assemblage comporte, comme évoqué précédemment, le collage moléculaire de la deuxième couche principale de silicium 10b sur la couche superficielle d'oxyde 20a. Ce collage est renforcé par un traitement thermique.

On observe que la structure obtenue après assemblage ne présente quasiment pas de déformation. En effet, dès lors que les épaisseurs des couches principales de silicium sont du même ordre de grandeur, les contraintes générées par la couche d'oxyde sur chacune des couches principales tendent à se compenser.

Le film superficiel de silicium d'une structure de type SOI est généralement un film mince dont l'épaisseur est adaptée aux exigences d'isolation électrique de composants, par exemple. La rigidité de la structure est assurée par la couche de silicium épaisse.

Ainsi, pour obtenir une structure SOI typique à partir de la structure de la figure 2, il convient d'amincir l'une des couches principales de silicium. L'amincissement peut avoir lieu par une des techniques d'amincissement connues dans différents procédé BSOI (Bonded Silicon On Insulator, silicium reporté sur isolant), BESOI (Bonded with Etch stop layer Silicon On Insulator, BSOI à couche d'arrêt de gravure). A ce sujet, on peut se reporter au document (7) dont la référence est précisée à la fin de la présente description.

Lorsque l'une des couches principales de silicium est amincie, il apparaît que les contraintes générées aux interfaces avec la couche d'oxyde de silicium ne sont plus compensées.

Les figures 3 et 4 montrent des structures obtenues respectivement par l'amincissement des couches principales 10b et 10a. Ces structures présentent une flèche et la surface de la couche de silicium mince est convexe dans chacun des cas.

On constate que l'épaisseur des couches principales mais aussi l'épaisseur de la couche d'oxyde de silicium enterrée, c'est-à-dire la couche d'oxyde prise en sandwich entre la couche principale et la couche superficielle mince, font partie des paramètres qui gouvernent la flèche de la structure finalement obtenue.

A titre d'exemple, pour un film d'oxyde thermique 20a enterré avec une épaisseur de l'ordre du micromètre, on obtient des valeurs de flèches qui peuvent être supérieures à $50\mu m$ lorsque le film mince superficiel de silicium 10a présente une épaisseur de $25\mu m$ et lorsque la couche principale de silicium a une épaisseur de l'ordre de 500 $\mu m$. Lorsque l'épaisseur du film superficiel de silicium est augmentée à plus de $50\mu m$, la flèche diminue à environ $25\mu m$. Ceci montre l'importance de l'épaisseur du film de silicium par rapport à celle du film d'oxyde.

Une mesure envisageable pour réduire les déformations de la structure consisterait à réaliser un deuxième film d'oxyde sur la face libre, appelé face arrière, de la couche principale épaisse de la structure. Cette mesure permettrait effectivement de réduire la déformation des plaques avant leur mise en contact. Dans un certain nombre d'applications, il est cependant nécessaire de retirer le film d'oxyde arrière. Or, après amincissement, si le film d'oxyde est retiré en face arrière, on constate que la déformation est restaurée et on obtient finalement une déformation de la structure SOI, principalement liée à l'épaisseur du film d'oxyde.

On peut se reporter à ce sujet au document (1) dont la référence est précisée à la fin de la description.

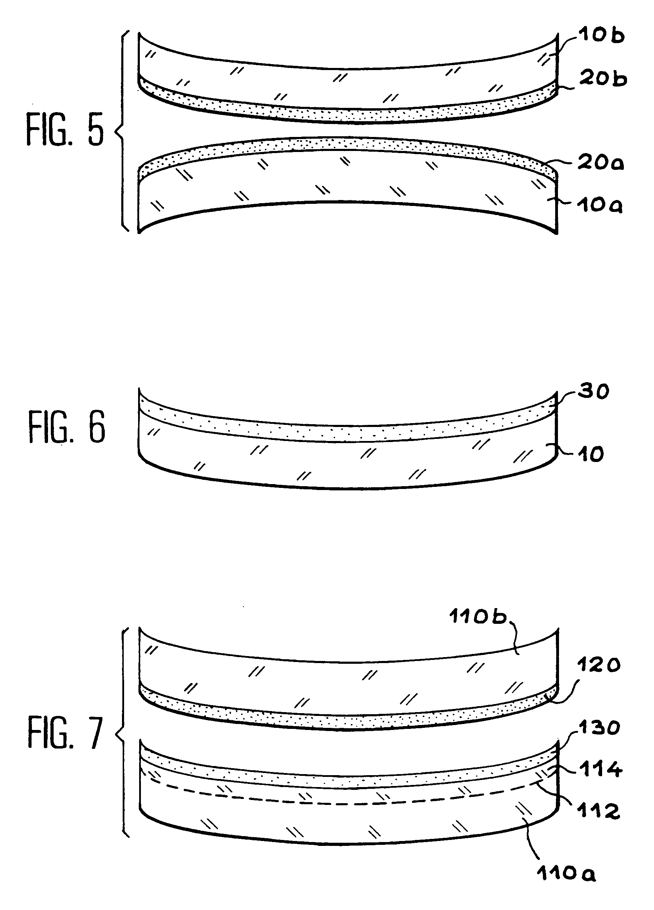

Selon une autre possibilité, illustrée par la figure 5, on peut tenter de réduire l'effet des contraintes en mettant en contact deux couches principales de silicium 10a, 10b équipées chacune d'un film d'oxyde 20a, 20b en surface, les films étant d'épaisseur comparable. On constate cependant qu'une déformation apparaît pour la structure lors de l'amincissement de l'une des couches. En outre, comme le montre la figure 5, la flèche initiale des deux couches principales augmente la difficulté de la mise en contact des surfaces des couches superficielles d'oxyde. Ceci peut générer localement des zones de mauvais contact et donc des évidements ou des défauts dans la structure finale.

Le phénomène de déformation décrit ci-dessus pour une structure combinant des couches de silicium et d'oxyde de silicium existe pour un grand nombre de couples de matériaux. Cependant, la déformation engendrée peut être variable en fonction des matériaux mis en contact et notamment du type de contrainte, en tension ou en compression qui apparaît.

A titre d'exemple, comme le montre la figure 6, lorsqu'un film de nitrure de silicium 30 est déposé sur une plaquette de silicium 10, ce dépôt peut engendrer, selon ses conditions de mise en oeuvre et après refroidissement, des contraintes conduisant également à une déformation.

Les contraintes entre le nitrure de silicium et le silicium ont des origines intrinsèques aux matériaux mais aussi des origines thermiques liées aux différences de coefficients de dilatation thermique. A titre d'exemple, le coefficient de dilatation thermique d'un film de nitrure de silicium obtenu par dépôt chimique en phase vapeur (CVD) est de l'ordre de $4,2.10^{-6}/K$ tandis que ce coefficient est de $2,6.10^{-6}/K$ pour le silicium. Le dépôt du nitrure de silicium ayant lieu à température élevée, de fortes contraintes apparaissent lors du refroidissement.

Toutefois, on observe, en comparant par exemple les figures 6 et 1, que la surface de la couche de nitrure de silicium 30 est concave, contrairement à la surface convexe de la couche d'oxyde de silicium 20a.

Cette différence de courbure traduit le fait que le nitrure de silicium et l'oxyde de silicium présentent, lorsqu'ils sont réalisés sur le support principal de silicium des contraintes de contact généralement opposées (tension-compression).

On comprend aussi que l'association de deux couches principales de silicium, recouvertes chacune d'un film de nitrure de silicium, conformément à la figure 6, peut également poser des problèmes d'adhérence ou de qualité de contact lorsque les films de nitrure sont en regard. En particulier des bulles sont susceptibles de se former à l'interface entre les couches de nitrure de silicium, générant localement des défauts dans la structure finale.

Pour une meilleure illustration des problèmes évoqués ci-dessus, on peut se reporter aux documents (2), (3), (4), (5) et (6) dont les références sont indiquées à la fin de la description et qui concernent les contraintes de contact entre couches différentes.

Le document (3) en particulier, montre qu'il est possible de compenser les effets de contraintes engendrées par un film superficiel d'oxyde de silicium formé à la surface d'une plaquette de silicium, en recouvrant ce film superficiel par un deuxième film de nitrure de silicium.

Une structure sensiblement plane peut être obtenue.

L'épaisseur du deuxième film (de nitrure) doit être contrôlée avec précision pour obtenir finalement une structure avec des faces planes.

Il s'avère cependant que les contraintes engendrées entre les couches ne sont pas simplement liées aux matériaux mis en contact, comme c'est le cas pour des couches réalisées par exemple par des dépôts consécutifs, mais sont liées aussi à la qualité de l'adhésion moléculaire entre les couches.

Ainsi, des traitements ultérieurs subis par une structure selon le document (3), ou l'association d'une telle structure avec d'autres couches, peuvent entraîner une modification de l'équilibre des contraintes de sorte que les contraintes finales de la structure sont difficilement maîtrisables.

Le document Patent Abstracts of Japan, vol. 18, n°213, 15 avril 1994 et JP-A-06 013 593 décrivent un moyen de réduire le gauchissement d'une structure multicouche en combinant, dans la structure, des films isolants ayant des coefficients de dilatation thermique différents. Un film isolant provoque une contrainte en traction tandis qu'un autre film isolant provoque une contrainte en compression.

Le document EP-A-0 410 679 divulgue la réalisation d'une structure SOI en faisant adhérer deux substrats de silicium par l'intermédiaire de couches d'oxyde. Avant leur adhésion, les substrats sont précontraints de manière que l'un soit concave et l'autre convexe. Après adhésion et amincissement de l'un des substrats, la structure SOI obtenue est plane.

Le document US-A-5 362 667 divulgue un procédé de fabrication d'une structure SOI comprenant l'adhésion de deux substrats par l'intermédiaire de couches isolantes. Il est proposé d'utiliser des couches intermédiaires d'oxynitrure, l'une permettant de contrôler les contraintes de l'autre couche.

Exposé de l'invention

Un but de la présente invention est de proposer un procédé de réalisation d'une structure multicouche, comportant au moins une étape d'adhésion, et permettant de contrôler avec précision les contraintes apparaissant dans la structure suite à l'association de couches de matériaux différents.

Un but est en particulier de proposer un tel procédé permettant de modifier et d'ajuster les contraintes pour obtenir une structure finale plane ou présentant une flèche prédéterminée.

Un but est de pouvoir transférer, en utilisant l'adhésion, au moins une couche cristalline pour obtenir une structure dont la contrainte est contrôlée.

Un but est aussi de proposer un tel procédé permettant de réaliser une structure exempte de défauts de contact aux interfaces entre les couches de matériaux différents.

Un but est encore de proposer un procédé susceptible de prendre en compte des traitements antérieurs ou postérieurs à la réalisation de la structure et qui soit compatible avec les exigences d'une mise en oeuvre industrielle tels que, par exemple, un traitement d'implantation en vue d'obtenir une séparation.

Pour atteindre ces buts, l'invention a plus précisément pour objet le procédé selon la revendication 1.

Par exemple, la première couche d'adaptation et la deuxième couche d'adaptation sont choisies (type de réalisation, nature, épaisseur) telles que si elles sont respectivement sur la première couche principale et sur la deuxième couche principale indépendamment (c'est-à-dire avant assemblage), elles provoquent des déformations en sens opposés. Ces déformations ne sont pas forcément de même amplitude.

Dans certains modes de réalisation, au moins une des couches d'adaptation est surmontée d'une couche intermédiaire pour permettre l'obtention de la structure multicouche désirée.

De façon avantageuse, on peut effectuer ensuite, après l'étape b), un traitement thermique avec une température et une durée suffisantes pour ajuster dans la structure ladite contrainte de structure déterminée.

Selon un mode préféré de réalisation, le collage par adhérence peut être un collage du type par adhérence moléculaire.

L'invention peut également utiliser un collage choisi parmi une brasure, une soudure, un collage au moyen d'une substance adhésive, une interdiffusion entre couches ou une combinaison de ces différentes techniques. Dans ces techniques, le collage a lieu au moyen d'une couche dite de collage. Cette couche de collage est soit entre les couches d'adaptation soit entre une des couches d'adaptation et la couche principale correspondante.

On entend par contrainte de structure la contrainte résultant des contraintes de chacune des couches d'adaptation, des contraintes de chacune des couches principales, et des contraintes liées à l'interface de liaison.

La contrainte de structure détermine la flèche convexe ou concave, ou le caractère plan des surfaces de la structure obtenue.

Le traitement thermique éventuellement effectué après l'étape b) permet non seulement d'améliorer la qualité du collage mais permet surtout, en ajustant le budget thermique mis en oeuvre, de modifier les contraintes de contact entre les couches de façon à ajuster l'équilibre des contraintes de tension et de compression.

Le budget thermique mis en oeuvre peut être ajusté en tenant compte notamment des budgets thermiques de traitements antérieurs ou postérieurs à l'étape c). Ainsi, d'autres traitements thermiques effectués sur la structure ne sont pas préjudiciables à l'obtention d'une contrainte donnée.

Le budget de traitement thermique est également ajusté en fonction d'autres paramètres gouvernant les contraintes dans les couches.

Parmi ces paramètres on peut citer :

- les matériaux mis en oeuvre et les traitements subis par ces matériaux,
- l'épaisseur des couches et leurs modes de réalisation,
- l'état de rugosité de la surface et la forme des couches mises en contact,
- la qualité du nettoyage des surfaces et leur caractère plus ou moins hydrophile.

La prise en compte de ces paramètres pour le choix du budget thermique permet d'adapter la contrainte interne de la structure finale et donc sa déformation. En particulier, les contraintes dans les couches d'adaptation de contraintes peuvent être augmentées, diminuées ou même inversées.

Selon une première possibilité de mise en oeuvre de l'invention, lors de l'étape a), on peut former la première couche d'adaptation de contraintes sur la première couche principale et la deuxième couche d'adaptation de contraintes sur la deuxième couche principale. Dans ce cas, lors de l'étape b), on effectue un collage entre les couches d'adaptation.

Comme les contraintes de contact des couches d'adaptation de contraintes avec les couches principales sont de signe opposé, l'une des couches d'adaptation de contraintes présente une surface convexe et la deuxième couche d'adaptation présente une surface concave.

Les surfaces à assembler présentent ainsi, dans une certaine mesure, une complémentarité de forme qui permet d'obtenir un contact de qualité exempt de défauts de collage tels que des évidements, ou des zones mal collées.

Selon une variante, les deux couches d'adaptation de contraintes peuvent être formées sur la première couche principale et le collage peut avoir lieu entre la deuxième couche principale et la couche d'adaptation de contraintes superficielle, solidaire de la première couche principale.

Selon un autre aspect de l'invention, avant l'étape b), on peut effectuer une préparation des couches devant être associées par collage moléculaire. pour ajuster un état de surface de ces couches et leur conférer, par exemple, un caractère hydrophile.

L'ajustement de l'état de la surface peut consister soit en un lissage (chimique, mécanochimique ou par traitement thermique) ou, au contraire, en une opération tendant à rendre la surface d'au moins une des couches à assembler plus rugueuse.

La modification de l'amplitude de la rugosité des faces à assembler permet de contrôler l'énergie d'adhésion entre les couches et donc les contraintes qui en résultent.

Selon l'invention, l'étape d'amincissement est réalisée dans l'une au moins des couches principales.

L'obtention d'une couche mince, en particulier sur une couche mince de silicium, au-dessus de couches d'adaptation de contraintes dont au moins une est isolante, est avantageuse par exemple pour la réalisation ultérieure de circuits électroniques intégrés (par exemple substrat SOI).

L'étape d'amincissement comprend au moins une implantation ionique d'espèces gazeuses dans l'une au moins des couches principales ou des couches d'adaptation pour y former une zone de fracture, et l'étape d'amincissement comporte une étape de séparation de ladite couche implantée selon la zone de fracture, par exemple par un traitement thermique et/ou mécanique. La contrainte de la structure sera alors modifiée par l'étape d'amincissement. En outre, la contrainte en cours de procédé peut être avantageusement utilisée en tant que contrainte "intermédiaire" de structure déterminée, pour participer à cet amincissement. La structure finale obtenue après amincissement, c'est-à-dire après séparation d'une des couches, présente une nouvelle contrainte de structure "finale" déterminée. La structure selon l'invention, dans certaines variantes, peut contenir un certain nombre de couches dont certaines peuvent être amincies, voire supprimées, leur rôle n'étant justifié dans certains cas que pour adapter la contrainte intermédiaire qui participe à l'amincissement. L'adaptation de la contrainte intermédiaire peut être un objectif en soi. L'utilisation d'une contrainte intermédiaire qui participe à la séparation permet de diminuer la dose d'espèces implantées (hydrogène et/ou gaz rares), et/ou le budget thermique et/ou le travail induit par la ou les forces mécaniques appliquées pour la séparation. Par exemple, elle permet d'obtenir la séparation avec un très faible budget thermique sur des structures où les couches principales présentent des coefficients de dilatation thermique différents. Le contrôle de la contrainte intermédiaire permet d'améliorer considérablement le procédé en modifiant soit les conditions d'implantation soit les conditions de séparation.

La réalisation d'une zone de fracture dans une couche par implantation d'espèces gazeuses peut avoir lieu selon des techniques en soi connues.

Par exemple, une des techniques utilise une implantation d'espèces gazeuse aptes à créer une couche fragilisée constituée de microcavités ou microbulles gazeuses.

On entend par "microcavité ou microbulle gazeuse" toute cavité générée par l'implantation d'ions de gaz hydrogène et/ou de gaz rares dans le matériau. Les cavités peuvent se présenter sous forme très aplatie, c'est-à-dire de faible hauteur, par exemple quelques distances inter-atomiques aussi bien que sous forme sphérique ou de tout autre forme différente de ces deux formes précédentes. Ces cavités peuvent contenir une phase gazeuse libre et/ou des atomes de gaz issus des ions implantés fixés sur des atomes du matériau formant les parois des cavités ; ces cavités peuvent même être vides.

Les cavités sont généralement appelées en terminologie anglo-saxonne "platelets", "microblisters" ou même "bubbles".

On entend par espèces gazeuses des éléments par exemple d'hydrogène ou de gaz rares sous leur forme atomique (par exemple H) ou sous leur forme moléculaire (par exemple $H_2$) ou sous leur forme ionique (par exemple $H^+$, $H_2^+$) ou sous leur forme isotopique (par exemple deutérium) ou isotopique et ionique.

On entend, par ailleurs, par implantation ionique tout type d'introduction des espèces définies précédemment, seul ou en combinaison tels que le bombardement ionique, la diffusion, etc.

Le traitement thermique de fracture est réalisé avec un budget thermique qui dépend du budget thermique fourni à la couche principale au cours de l'implantation, et pendant les étapes qui ont lieu avant la fracture. Suivant le cas, ce traitement thermique peut être nul en temps et/ou température. De plus, ce traitement thermique peut être ajusté en fonction d'autres contraintes exercées, telles que, par exemple, des forces mécaniques, de traction, de cisaillement, de flexion, etc. exercées seules ou en combinaison.

Le traitement thermique conduit, quel que soit le type de matériau solide, à la coalescence des microcavités qui amènent une fragilisation de la structure au niveau de la couche de microcavités. Cette fragilisation permet la séparation du matériau sous l'effet de contraintes internes et/ou de pression dans les microcavités, cette séparation pouvant être naturelle ou assistée par application de contraintes externes.

Les forces mécaniques peuvent être appliquées perpendiculairement aux plans des couches et/ou parallèlement à celles-ci. Elles peuvent être localisées en un point ou une zone ou être appliquées à différents endroits de façon symétrique ou dissymétrique.

En outre, si on veut adapter la contrainte de structure finale, le budget thermique de la fracture est pris en compte pour établir le budget thermique de l'étape d'adaptation. L'étape d'adaptation des contraintes de la structure finale peut également inclure une étape d'amincissement, par exemple par oxydation sacrificielle et/ou attaque chimique et/ou gravure plasma et/ou polissage.

Plusieurs possibilités peuvent être envisagées pour la réalisation des couches d'adaptation de contraintes.

Selon une première possibilité au moins l'une des couches d'adaptation de contraintes peut être formée par dépôt de matière selon un procédé de dépôt choisi par exemple parmi les procédés de pulvérisation, d'épitaxie, de dépôt chimique, tel que dépôt chimique en phase vapeur, le dépôt en phase vapeur à basse pression, et le dépôt chimique en phase vapeur assisté par plasma.

Selon une variante, une couche d'adaptation de contraintes peut également être obtenue par oxydation superficielle d'une des couches principales.

En particulier, lorsque l'une des couches principales est une couche de silicium, l'une des couches d'adaptation peut être une couche d'oxyde thermique $SiO_2$.

Selon une troisième possibilité, au moins une couche d'adaptation de contraintes peut être obtenue par implantation d'espèces dans une couche principale.

L'implantation d'espèces dans l'une des couches principales permet de former à la surface de cette couche une zone dont les propriétés sont modifiées.

En particulier, l'implantation d'espèces permet de générer des contraintes ou de modifier localement la densité du matériau. La profondeur où est située la majorité des espèces implantées dépend des conditions de l'implantation. Par exemple de son énergie, si l'implantation est de type implantation ionique. Le film d'espèces implantées, défini par cette profondeur, et son voisinage, où est localisée la majorité des espèces implantées, constitue alors une des couches du bicouche de contraintes. Le film compris entre ce film d'espèces implantées et la surface de la deuxième couche principale peut constituer un des deux films du bicouche de contraintes.

L'intensité des contraintes peut être adaptée en fonction de la nature des espèces, de la dose ou des divers paramètres d'implantation (température, courant d'implantation, énergie,...). L'implantation peut en particulier être réalisée avec des espèces gazeuses, par exemple hydrogène et/ou gaz rares.

La présence d'une contrainte dans la structure participe à la séparation et permet de diminuer la dose d'espèces implantées (hydrogène et/ou gaz rares), et/ou le budget thermique et/ou le travail induit par le ou les forces mécaniques appliquées pour la séparer. Ainsi, la présence de cette contrainte permet de modifier soit les conditions d'implantation soit les conditions de séparation. Le contrôle de la contrainte permet de considérablement améliorer le procédé. Il permet par exemple d'avoir la fracture avec un très faible budget thermique sur des structures où les couches principales présentent des coefficients de dilatation thermique différents. L'implantation pourra être réalisée avant ou après assemblage de la structure.

Dans certains cas où une au moins des couches d'adaptation est suffisamment épaisse et/ou rigide, la couche principale normalement adjacente peut être omise ou confondue avec cette couche d'adaptation. Après séparation, on obtient une couche principale modifiée et un empilement multicouche, ce dernier pouvant être réutilisé comme couche principale comprenant une couche d'adaptation de contrainte.

Le procédé de réalisation décrit ci-dessus est applicable à des couches principales en des matériaux divers. Les couches principales en des matériaux identiques ou différents peuvent être par exemple en matériaux monocristallins, polycristallins ou amorphes, et par exemple en silicium, en germanium, en carbure de silicium, en semi-conducteur de type III-V ou II-VI, tels que GaAs ,GaN, InP,... en verre ou en quartz, en matériaux supraconducteurs, en diamant, ou en des matériaux céramiques (tels que $LiTaO_3$, $LiNbO_3$, ...).

Ainsi, la couche principale peut être formée d'une ou de plusieurs couches par exemple collées, déposées, ou épitaxiées.

Les couches d'adaptation de contraintes sont par exemple en un matériau choisi parmi $SiO_2$, SiN, $Si_3N_4$, TiN, le diamant et les métaux (tels que Pd, des alliages, ...) ou en un des matériaux pouvant constituer une des couches principales ou en une combinaison de ces matériaux.

L'invention permet d'obtenir une structure multicouche à contraintes internes contrôlées comprenant, dans l'ordre, un empilement d'une première couche principale, d'au moins une première couche d'adaptation de contraintes en contact avec la première couche principale, d'au moins une deuxième couche d'adaptation de contraintes en contact avec ladite première couche d'adaptation de contraintes et d'une deuxième couche principale en contact avec la deuxième couche d'adaptation de contraintes. Dans cette structure, les première et deuxième couches d'adaptation de contraintes présentent des contraintes de contact avec les première et deuxième couches principales qui sont respectivement de signe opposé.

La structure présente une membrane suspendue, la membrane suspendue comportant au moins une portion de l'une des première et deuxième couches principales, libérée de la deuxième respectivement de la première couche principale.

La membrane suspendue peut supporter d'autres couches fonctionnelles. Par exemple, elle peut comporter en outre au moins une couche de matériau supraconducteur recouvrant ladite portion de l'une des première et deuxième couches principales.

D'autres caractéristiques et avantages de la présente invention ressortiront mieux de la description qui va suivre, en référence aux figures des dessins annexés. Cette description est donnée à titre purement illustratif et non limitatif.

Brève description des figures

- La figure 1, déjà décrite, est une coupe schématique d'une première et d'une deuxième couches principales avant assemblage, l'une des couches étant recouverte d'un film superficiel en un matériau susceptible d'engendrer des contraintes internes.
- La figure 2, déjà décrite, représente une structure comprenant les couches de la figure 1, après assemblage.
- Les figures 3 et 4, déjà décrites, représentent en coupe schématique la structure de la figure 2 après amincissement de l'une des couches principales.
- La figure 5, déjà décrite, représente schématiquement une paire de couches principales supportant chacune une couche superficielle présentant une contrainte de tension.
- La figure 6, déjà décrite, représente schématiquement une couche principale supportant une couche superficielle présentant une contrainte de tension.
- Les figures 7, 8 et 9 sont des coupes schématiques montrant des étapes de fabrication d'une structure multicouche selon une mise en oeuvre particulière du procédé de l'invention.
- La figure 10 est un graphique indiquant, en échelle arbitraire, les valeurs de flèche de la structure obtenue par le procédé, en fonction de paramètres de traitement thermiques.
- Les figures 11 à 15 sont des coupes schématiques montrant des étapes successives d'une autre possibilité de mise en oeuvre du procédé de l'invention.
- Les figures 16 à 18 sont des coupes schématiques, montrant des étapes successives de réalisation d'une structure à membrane suspendue et illustrant une application particulière de l'invention.
- La figure 19 est une coupe schématique d'une structure constituant une variante de la structure de la figure 18.
- La figure 20 est une coupe schématique d'une structure constituant une autre variante de la structure de la figure 18.

Description détaillée de modes de mise en oeuvre de l'invention

Un premier exemple de mise en oeuvre concerne la réalisation d'une structure empilée constituée d'un film de silicium très mince et d'une bicouche d'adaptation de contraintes supportés par un substrat de silicium épais. La réalisation décrite fait appel à un procédé de séparation pour former la couche mince superficielle de silicium.

Dans une première étape illustrée par la figure 7, un film de nitrure de silicium $Si_3N_4$ 130, d'une épaisseur de 400 nm, est formé selon un procédé de dépôt en phase vapeur à basse pression (LPCVD), sur une plaque de silicium qui forme une première couche principale 110a. Le dépôt en phase vapeur à basse pression permet de réaliser un film induisant une faible flèche sur la couche principale. Ceci est le cas notamment si le dépôt est réalisé sur les deux faces de cette couche.

Le film de nitrure de silicium 130 constitue une première couche d'adaptation de contrainte.

Selon une variante de mise en oeuvre de l'invention, cette couche d'adaptation peut être surmontée d'une couche intermédiaire réalisée par exemple par un film d'oxyde de silicium et par un film d'oxynitrure de silicium, par exemple de quelques nm d'épaisseur. Cette couche intermédiaire dans ce cas permet soit de favoriser le collage par adhérence moléculaire utilisé pour l'assemblage soit d'améliorer la qualité électrique de l'interface avec la couche principale.

La plaque de silicium est éventuellement recouverte au préalable, d'une très fine couche d'oxyde de silicium, non représentée, par exemple d'une épaisseur de 10 nm. L'intérêt d'une telle couche très fine est, par exemple de constituer une interface de très bonne qualité électronique avec une couche de silicium superficielle décrite ci-après.

Après la formation du film de nitrure 130, une implantation d'hydrogène est pratiquée à travers le film 130 avec une dose d'implantation de l'ordre de $2,5.10^{16}$ at/cm$^2$. L'implantation conduit à la formation d'une zone de fracture repérée avec la référence 112. Les paramètres d'implantation d'hydrogène peuvent être changées lorsque la flèche du film de nitrure est changée, en fonction des conditions de dépôt par exemple.

Sur une seconde plaque de silicium 110b, également représentée sur la figure 7, on réalise un film 120 d'oxyde de silicium par un traitement thermique sous atmosphère oxydante. L'épaisseur du film d'oxyde est sensiblement équivalente à celle du film de nitrure 130.

La seconde plaque de silicium 110b et le film 120 d'oxyde forment respectivement une deuxième couche principale et une deuxième couche d'adaptation de contraintes.

Les couches de nitrure de silicium et l'oxyde de silicium initialement formée sur les couches principales de silicium, engendrent des contraintes de contact de signe opposé. Ceci se traduit par des déformations des couches principales telles que les surfaces des couches d'adaptation de contraintes de nitrure et d'oxyde sont respectivement concave et convexe.

Le procédé est poursuivi par une étape de nettoyage des plaques destinée à rendre hydrophile la surface des couches d'adaptation de contraintes 120, 130. Le nettoyage permet d'obtenir une micro-rugosité de surface contrôlée, de valeur quadratique (RMS en anglais) typiquement inférieure à 0,7 nm, ce qui est compatible avec une adhésion moléculaire directe. La micro-rugosité peut être mesurée et contrôlée par microscopie à force atomique par exemple dans une gamme de fréquences spatiales de $10^{-2}\mu m^{-1}$ à $10^3\mu m^{-1}$. Le contrôle de la rugosité de surface, par l'étape de nettoyage des plaques avant collage, est présenté ici comme un avantage sur les technique de polissage de surface, pour un film de nitrure de silicium, dont l'épaisseur peut atteindre au moins plusieurs dixièmes de microns.

L'étape de nettoyage permet d'induire une modification de l'énergie de liaison et donc d'induire une modification de la contrainte spécifique de la bicouche formée ultérieurement par le collage des couches d'adaptation de contrainte.

En outre, l'étape de nettoyage permettant d'affranchir le procédé d'une étape de polissage mécanochimique, une bonne homogénéité en épaisseur des films de la structure empilée, formée dans une étape subséquente, est également assurée.

L'étape suivante du procédé comporte effectivement la mise en contact directe des couches d'adaptation de contraintes pour provoquer leur collage. Cette opération a lieu à température ambiante.

On comprend au vu de la figure 7 que le caractère complémentaire de la déformation des couches permet de minimiser le risque d'un mauvais contact.

Après le collage, un premier traitement thermique opéré pendant 30 minutes à une température de 500°C permet de provoquer une fracture dans la zone de fracture 112 indiquée sur la figure 7 et donc de détacher de la première couche principale 110a une fine couche superficielle 114. Cette couche superficielle reste solidaire de la deuxième couche principale 110b par l'intermédiaire de la bicouche formée par les couches d'adaptation de contraintes 120, 130 associées éventuellement à des couches intermédiaires. Le traitement thermique peut être assisté en tout ou partie par l'application de contraintes mécaniques. En conséquence, le budget thermique nécessaire à la fracture peut être réduit. Il peut être nul en temps et en température.

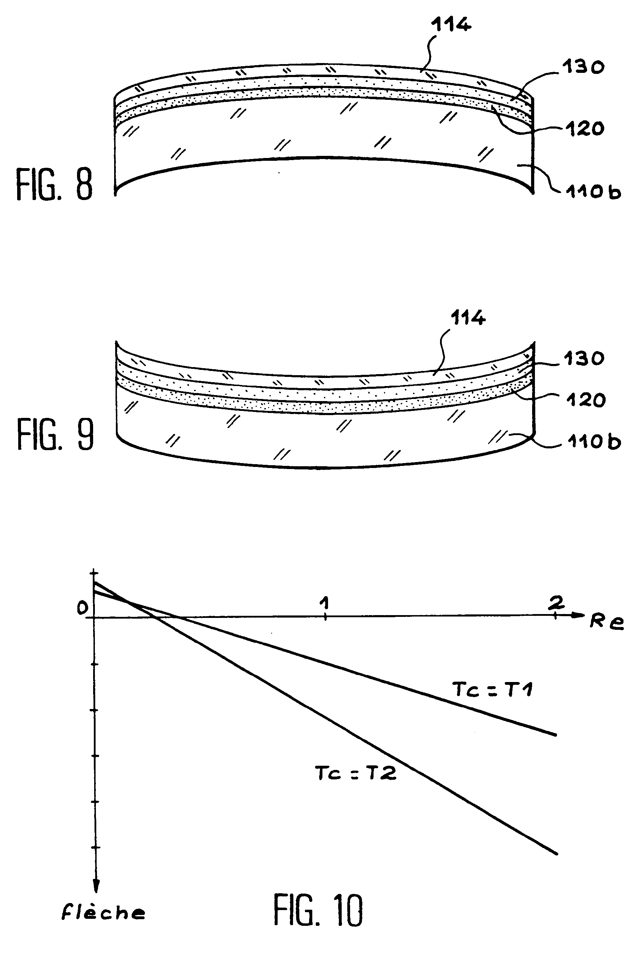

La structure obtenue est illustrée par les figures 8 et 9.

L'épaisseur de la couche mince superficielle de silicium 114 est de l'ordre de quelques dixièmes de micromètres. Elle est fixée par la profondeur de pénétration des espèces gazeuses de la couche de séparation (fracture) implantées dans la première couche principale de silicium. Comme l'implantation a lieu à travers le film 130 de nitrure de silicium, la profondeur d'implantation et donc l'épaisseur de la couche mince 114 de silicium dépendent aussi de l'épaisseur du film 130 de nitrure de silicium.

Le fait que la première couche principale 110a soit équipée d'une couche d'adaptation de contraintes, permet de réduire la dose d'implantation nécessaire à la fracture dans la zone 112 et/ou de réduire le budget thermique du premier traitement thermique de fracture et/ou les forces mécaniques de séparation. Les contraintes spécifiques induites par les couches d'adaptation de contrainte et notamment la couche de nitrure de silicium 130, dans la première couche principale de silicium 110a favorisent en effet la fracture.

Par exemple, un gain en température, en énergie et finalement en coût peut être obtenu.

A titre de comparaison, dans les mêmes conditions d'implantation (énergie, courant, température,...) et de traitement thermique de transfert, la dose minimale pour obtenir une séparation est de $3,5.10^{16}$ at/cm$^2$, pour une structure empilée classique où le film de nitrure serait remplacé par un film d'oxyde thermique de 400 nm d'épaisseur.

Dans une étape suivante, un deuxième traitement thermique est effectué. Ce traitement a une double fonction de rendre plus intime les liaisons à l'interface entre les deux couches d'adaptation de contraintes préalablement mises en contact, et de modifier ou ajuster les contraintes induites au sein de la structure finalement obtenue.

En adaptant les épaisseurs des couches de l'empilement, leur état de surface avant mise en contact et surtout le budget thermique du deuxième traitement, il est possible de contrôler les contraintes générées par la bicouche 120, 130 et donc de contrôler la déformation convexe ou concave de la structure finale (figures 8 et 9).

A titre d'exemple, dans le cadre de l'application à un dispositif à membrane, il peut être avantageux de réaliser une structure empilée de forme concave, qui permet après la libération partielle de la membrane, d'obtenir une membrane pré-tendue.

Selon le budget thermique mis en oeuvre, une flèche positive, négative, ou nulle peut être obtenue.

Le deuxième traitement thermique prend en compte, bien entendu, le budget thermique du premier traitement thermique et éventuellement l'utilisation de contraintes mécaniques.

A titre d'exemple, le deuxième traitement thermique peut être effectué à une température de 1100°C pendant 2 heures. Pour des films d'oxyde et de nitrure de même épaisseur, de l'ordre de 400 nm, on obtient une concavité de la structure avec une flèche d'environ 50μm.

La flèche de la structure empilée finale dépend principalement de deux paramètres qui sont le rapport Re des épaisseurs $E_{nit}$ et $E_{ox}$ des couches de nitrure 120, et d'oxyde de silicium 130, d'adaptation de contraintes et le budget thermique appliqué à la structure. L'effet du rapport d'épaisseur des couches, à température de scellement fixée, traduit le fait que la flèche de la structure est proportionnelle à la contrainte effective et à l'épaisseur des couches d'adaptation.

Il apparaît en outre de façon originale, que lorsque la température $T_c$ du deuxième traitement thermique mis en oeuvre varie, la contrainte effective de la bicouche est modifiée. L'effet du traitement thermique appliqué dépend en particulier de l'état de l'interface d'adhésion (micro-rugosité, densité de liaisons entre les couches, ...). A titre d'exemple, pour un rapport Re=1, une augmentation de température $\Delta T_c$=100°C entraîne une augmentation $\Delta\sigma/\sigma$ de la contrainte dans la bicouche telle que $\Delta\sigma/\sigma$=100%.

La figure 10 est un graphique qui indique en unités arbitraires la flèche de la structure finalement obtenue en fonction du rapport d'épaisseur des couches d'adaptation de contraintes

$$(Re = \frac{E_{nitrure}}{E_{oxyde}})$$ et pour deux températures

de traitement différentes $T_1$ et $T_2$ telles que $T_2 > T_1$.

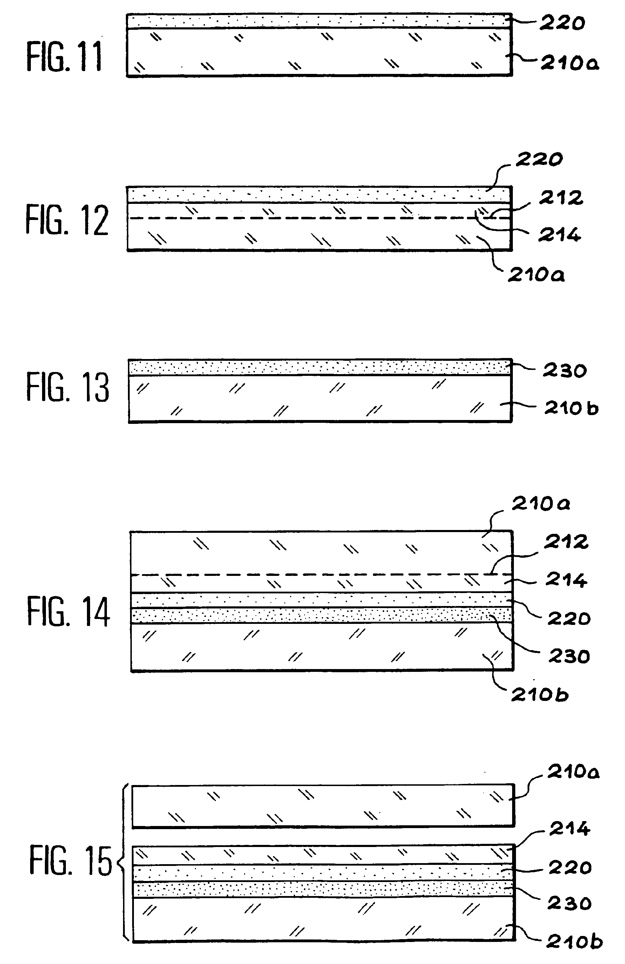

Dans un second exemple de mise en oeuvre du procédé, décrit ci-après en référence aux figures 11 à 15, la bicouche d'adaptation de contraintes est constituée d'un film de $SiO_2$ et d'une couche implantée dans l'une des couches principales.

Comme le montre la figure 11, une première couche d'adaptation de contrainte 220 est formée par implantation d'espèces dans une plaquette de silicium. La partie de cette plaquette non affectée par l'implantation forme la première couche principale 210a.

A titre d'exemple, l'implantation peut avoir lieu avec de l'azote avec une dose de $10^{16}$ atomes/cm² et avec une énergie de 135 keV.

Avec une telle implantation, la couche d'adaptation de contraintes 220, c'est-à-dire la zone perturbée par l'implantation, induit une contrainte en compression de quelques dizaines de MPa. Pour des raisons de simplification les déformations des couches induites par les contraintes ne sont plus représentées sur les figures 11 à 15.

Une deuxième implantation plus profonde, illustrée à la figure 12, est alors effectuée avec des espèces gazeuses. Cette implantation a lieu à la travers la couche d'adaptation de contraintes 220 pour former une couche de séparation (fracture) 212.

A titre d'exemple, on peut implanter une dose d'hydrogène de l'ordre de $5.10^{16}$ atomes/cm².

L'énergie, et donc la profondeur d'implantation, permet de définir dans la couche principale 210a une couche superficielle mince 214 plus ou moins épaisse. Celle-ci est délimitée par la couche de séparation 212.

Par ailleurs, comme le montre la figure 13, un film d'oxyde de silicium ($SiO_2$) 230, d'une épaisseur de l'ordre de 200nm est formé à la surface d'une autre plaquette de silicium qui constitue la deuxième couche principale 210b. Le film d'oxyde de silicium 230 forme une couche d'adaptation de contraintes.

Les couches principales, équipées des couches d'adaptation de contraintes sont alors nettoyées de sorte que la micro-rugosité et le caractère hydrophile des couches d'adaptation de contraintes permettent une adhésion moléculaire dès la mise en contact de ces couches.

L'assemblage de couches principales, par mise en contact des couches d'adaptation de contraintes, est illustré à la figure 14.

La mise en contact de la couche d'oxyde de silicium 230 et la couche implantée 220 permet de constituer également une bicouche d'adaptation de contraintes.

Dans certains cas, où une au moins des couches d'adaptation est suffisamment épaisse et/ou rigide, la couche principale normalement adjacente peut être omise ou confondue avec cette couche d'adaptation.

Un premier traitement thermique, dit de transfert (qui permet éventuellement aussi de renforcer l'adhésion entre les couches d'adaptation de contraintes) est effectué avec un budget thermique suffisant pour permettre une fracture selon la couche de fracture. Ce traitement thermique peut être appliqué, par exemple, de façon continue, variable ou impulsionnelle. Ce traitement thermique de transfert peut être éventuellement assisté par l'application de forces mécaniques, par exemple par traction et/ou cisaillement et/ou flexion. Suivant les contraintes appliquées, le budget thermique peut être effectué à température et temps réduits, voire nuls. La fracture permet de séparer la couche mince 214 et la première couche principal 210a, comme le montre la figure 15. Ces contraintes générées par la bicouche d'adaptation de contraintes peuvent également permettre de diminuer la dose d'espèces implantées et réduire le budget thermique du traitement de transfert et/ou les forces mécaniques de séparation.

Par exemple, une séparation (fracture) peut être provoquée en chauffant la structure à 450°C pendant 30 minutes. En comparaison, pour provoquer une séparation dans un substrat comparable à la figure 12, en l'absence des couches d'adaptation de contraintes, un traitement à une température d'au moins 500°C serait nécessaire, pendant 30 minutes pour obtenir une séparation.

Enfin, un traitement thermique final est réalisé.

Dans la structure empilée, chacune des couches d'adaptation de contraintes de la bicouche est soumise à une contrainte effective dont la résultante peut être globalement modifiée par les mécanismes d'adhésion des deux plaques et par les divers traitements thermiques appliqués. La structure empilée finale est soumise alors à une contrainte adaptable en particulier par le traitement thermique final.

Les divers traitements thermiques peuvent être avantageusement assistés mécaniquement (par exemple par traction, compression, cisaillement, flexion ou par application de champs électrostatiques ou magnétiques suivant la nature des couches) pour induire un effet supplémentaire de contraintes dans la bicouche spécifique.

Selon un troisième exemple, une variante de mise en oeuvre non représentée sur les figures, consiste à ne pas effectuer l'amincissement d'une des couches principales par la fracture de transfert de couches. Les autres étapes de préparation étant comparables à celles décrites dans le deuxième exemple de mise en oeuvre, l'amincissement d'une des couches principales, s'il est souhaité, peut être réalisé alors par abrasion mécanique et/ou chimique simple.

Selon un autre mode de mise en oeuvre d'application de l'invention, on peut réaliser dans la couche superficielle, obtenue après amincissement, et dans tout ou partie des couches d'adaptation et des couches intermédiaires de la structure finale, des composants tels que des membranes, dans lesquels la contrainte effective est contrôlée lors de la réalisation de la structure empilée. L'avantage d'une telle approche est de pouvoir disposer de la surface de la couche superficielle, par exemple, pour y réaliser une épitaxie sans avoir à y déposer des couches d'adaptation de contraintes des membranes, lors de l'élaboration de celles-ci.

A titre d'exemple d'application de cet autre mode de mise en oeuvre, on peut citer l'épitaxie de supraconducteur de type YBaCuO sur une couche superficielle de silicium en vue de réaliser un bolomètre en membrane. Cette épitaxie suppose habituellement de façon avantageuse l'utilisation de couches d'adaptation d'épitaxie, dites "buffer" (tampon) et "seed layers" (de germe) en anglais. Elles ont pour but l'adaptation du paramètre cristallin entre le supraconducteur et le silicium. Ces couches peuvent être en MgO, $CeO_2$ $ZrO_2$, par exemple pour le cas de l'YBaCuO déposé sur silicium.

La couche superficielle de silicium est celle obtenue par le procédé décrit au préalable, c'est-à-dire par implantation d'hydrogène et séparation, et la contrainte de la structure empilée, comprenant la bicouche d'adaptation de contrainte, obtenue en fin de procédé d'élaboration de cette couche de silicium est alors primordial pour la qualité de la ou des épitaxies consécutives dans la mesure où elle permet de disposer d'un support précontraint mieux adapté à ces épitaxies.

En outre, il est alors avantageux de pouvoir réaliser des membranes, par exemple par gravure, avant le dépôt du supraconducteur par épitaxie.

Bien que la description qui précède se rapporte à des couches principales massives en silicium, on entend que les couches principales peuvent elles-mêmes présenter une structure multicouche avec une pluralité de sous-couches.

Par ailleurs, lorsque l'on a une couche d'adaptation en oxyde de silicium, celle-ci peut être formée par un oxyde natif, thermique ou déposé.

En outre, les couches principales peuvent inclure des composants électroniques, mécaniques ou optiques formés préalablement ou postérieurement aux traitements décrits.

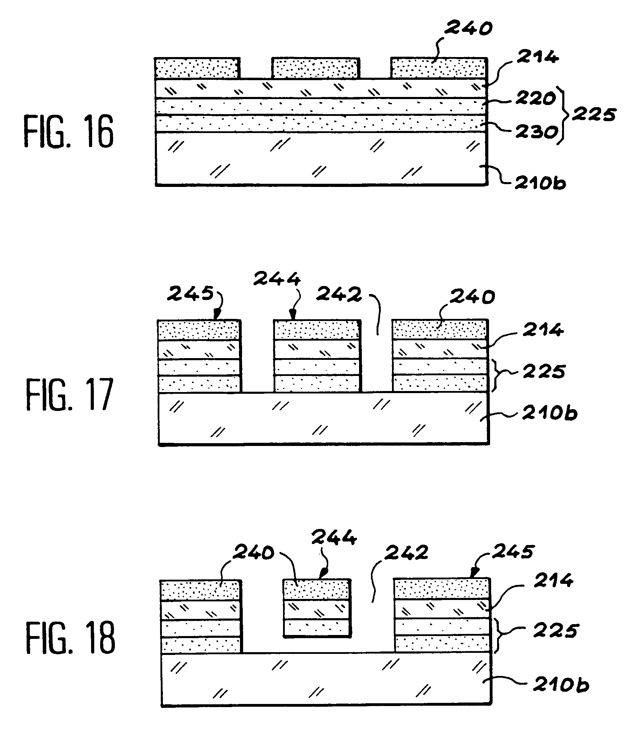

Un exemple particulier d'application de l'invention est décrit à présent en référence aux figures 16 à 20 qui illustrent en coupe, différentes étapes et possibilités de réalisation d'une structure à membrane suspendue.

La figure 16 montre une structure multicouche comparable à celle de la figure 15, au terme de l'amincissement ou la fracture de la première couche principale.

En utilisant les mêmes références pour des parties identiques ou similaires à ceux de la figure 15, la structure de la figure 16 comporte une couche mince 214 de silicium, provenant de la première couche principale, une paire de couches d'adaptation de contraintes 220, 230 et une deuxième couche principale 210b, également en silicium, qui constitue ici un substrat de support.

Pour des raisons de simplification, la paire de couche d'adaptation de contraintes, ou bicouche, est désignée dans la suite du texte par une unique référence 225.

La couche mince 214 est recouverte d'un masque de gravure 240 présentant un motif correspondant à des contours d'une membrane que l'on souhaite réaliser dans la structure. Plus précisément, le masque présente des ouvertures qui laissent à nu des zones de la structure devant être gravées pour définir la forme de la membrane suspendue.

Le masque 240 est par exemple un masque de résine photosensible, mis en forme par insolation à travers un masque d'insolation, puis par développement.

Une première gravure anisotrope à travers les ouvertures du masque 240 permet de former des tranchées 242 qui s'étendent à travers la couche mince 214 et tout ou partie de la bicouche d'adaptation de contraintes 225. La gravure peut aussi être arrêtée sur la deuxième couche principale. L'arrêt de gravure peut être facilité par une couche d'arrêt de gravure, non représentée, mise en place sur la deuxième couche principale avant la formation de la structure multicouche.

Les tranchées délimitent une partie centrale 244 destinée à former ultérieurement la membrane suspendue. Il convient de préciser, cependant, que les tranchées n'entourent pas totalement la partie centrale 244 mais préservent des "ponts" qui la relient à la structure 245 entourant la partie centrale. Ces "ponts" qui ne sont pas visibles, car en dehors du plan de coupe des figures, peuvent constituer éventuellement dans la structure finale des poutrelles de maintien de la membrane suspendue permettant ainsi par exemple une conduction électrique et/ou thermique.

Une étape suivante, illustrée par la figure 18 comprend une gravure anisotrope sélective permettant d'éliminer au moins une partie de la bicouche d'adaptation de contraintes pour libérer une portion de la couche mince, en l'occurrence la partie centrale 244 qui constitue désormais une membrane suspendue.

Pour des raisons de simplification, la figure ne tient pas compte d'une éventuelle attaque des flancs latéraux de la bicouche 225 dans les tranchées, lors de la gravure anisotrope.

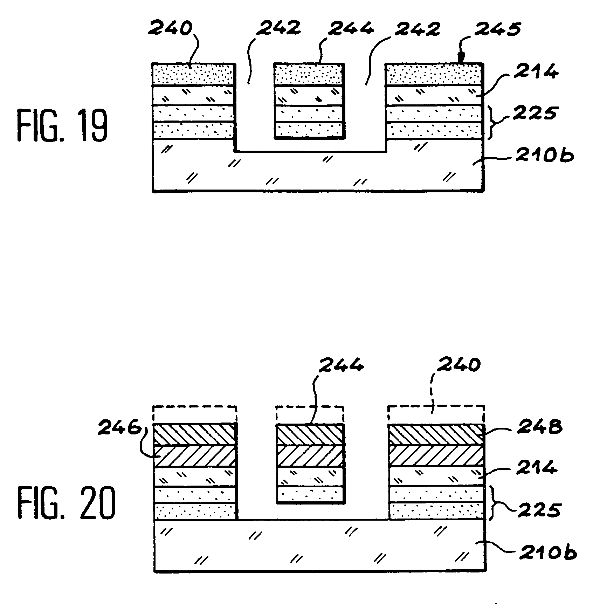

La figure 19 illustre une variante dans laquelle la membrane est libérée au moyen d'une gravure anisotrope qui permet d'attaquer sélectivement la deuxième couche principale 210b, c'est-à-dire le substrat de support.

La membrane peut aussi être libérée par une gravure combinée de la deuxième couche principale et de la bicouche d'adaptation de contraintes.

Enfin, au terme des gravures, la couche de résine formant le masque 240 peut être éliminée.

La figure 20 montre une réalisation particulière, comparable à celle de la figure 18, dans laquelle des couches additionnelles ont été formées sur la couche mince 214 avant la gravure.

Les couches additionnelles comportent dans l'exemple une couche 246 de germe et/ou une couche de tampon, et une couche 248 de matériau supraconducteur, par exemple de type YBaCuO.

La couche 246 de germe et/ou une couche de tampon non représentée, permettent de favoriser la croissance du matériau supraconducteur sur la couche mince de silicium et/ou permettent de corriger un éventuel désaccord de maille cristalline entre le silicium de la couche mince et le supraconducteur. Ces couches sont gravées de la façon déjà décrite en référence aux figures 18 ou 19 pour obtenir la structure finale de la figure 20 avec une membrane suspendue 244.

L'emplacement du masque de gravure 240, retiré, est indiqué en trait discontinu.

Une application possible d'une structure à membrane suspendue telle que décrite, est la réalisation de dispositifs de type bolomètre, par exemple.

## DOCUMENTS CITES

(1)
Bower et al., Appl. Phys. Lett. 62, 26, 1993, p. 3485.
(2)
M. Tamura et al., Jpa. J. Appl. Phys., vol. 11, n°8, August 1972, p. 1097.
(3)
H. Mikoshiba, J. Electrochem. Soc., vol. 123, n°10, October 1976, p. 1539.
(4)
S. Sanchez et al., J. Michromech. Microeng. 7 (1997), p.111-113.
(5)
Harendt et al., Sensors and Actuators A, 25-27 (1991), p. 87-92
(6)
C. Gui, M. Elwenspoek, J.G.E. Gardeneiers, P.V. Lambeck, E.C.S. vol. 97-36, 1997, p. 114.
(7)
FR-A-2 681 472

## Revendications

1. Procédé de réalisation d'une structure multicouche présentant une contrainte de structure déterminée et destinée à des applications en microélectronique ou en micromécanique, dans lequel :

   a) on équipe une première plaque (110a, 210a) d'une première couche d'adaptation (130, 220) des contraintes induites dans la structure lors d'un traitement thermique, et on équipe, d'au moins une deuxième couche d'adaptation (120, 230) des contraintes induites dans la structure lors d'un traitement thermique, l'une parmi une deuxième plaque (110b, 210b) et la première couche d'adaptation (130, 220), les première et deuxième couches d'adaptation étant réalisées en des matériaux et avec des épaisseurs tels qu'en fin de procédé on obtienne dans la structure ladite contrainte de structure déterminée ;
   b) on effectue un assemblage des première et deuxième plaques par l'intermédiaire des couches d'adaptation des contraintes ;
   c) on effectue, après l'étape b), un traitement thermique à une température et pour une durée suffisantes pour ajuster dans la structure ladite contrainte de structure déterminée ;
   d) on effectue après l'étape d'assemblage, une étape d'amincissement de l'une au moins des première et deuxième plaques, cette étape d'amincissement comportant une étape de séparation pour fracturer la plaque à amincir selon une zone de fracture réalisée avant l'étape d'assemblage, ladite zone de fracture étant réalisée par au moins une implantation d'espèces gazeuses dans l'une au moins des première et deuxième plaques.

2. Procédé selon la revendication 1, dans lequel ledit assemblage des première et deuxième plaques comprend un collage par adhérence.

3. Procédé selon la revendication 1 ou 2, dans lequel les première et deuxième couches d'adaptation sont réalisées en des matériaux et avec des épaisseurs tels que les contraintes avec les première et deuxième plaques soient respectivement de signe opposé.

**4.** Procédé selon la revendication 1, dans lequel au moins l'une des couches d'adaptation de contraintes est surmontée d'au moins une couche dite intermédiaire.

**5.** Procédé selon la revendication 1 ou 2, dans lequel ledit assemblage comprend un collage par adhésion moléculaire entre couches.

**6.** Procédé selon la revendication 5, dans lequel avant l'étape b) on effectue une préparation des couches devant être associées par collage moléculaire, pour ajuster leur état de surface.

**7.** Procédé selon la revendication 5, dans lequel lors de l'étape b) le collage moléculaire est réalisé à température ambiante.

**8.** Procédé selon la revendication 1, dans lequel ledit assemblage comprend un collage mettant en oeuvre au moins une technique de collage choisie parmi : la brasure, la soudure, l'interdiffusion entre couches, et collage par substance adhésive.

**9.** Procédé selon la revendication 1, dans lequel l'assemblage a lieu par l'intermédiaire d'une couche d'adhésion.

**10.** Procédé selon la revendication 1, dans lequel lors de l'étape a) on forme la première couche d'adaptation de contraintes (130, 220) sur la première plaque (110a, 210a) et la deuxième couche d'adaptation de contraintes (120, 230) sur la deuxième plaque (110b, 210b), et dans lequel, lors de l'étape b), on effectue un collage moléculaire entre les couches d'adaptation de contraintes.

**11.** Procédé selon la revendication 1, dans lequel les première et deuxième couches d'adaptation de contraintes sont formées sur la première plaque et le collage a lieu entre la deuxième plaque et l'une des première et deuxième couches d'adaptation de contrainte superficielle.

**12.** Procédé selon la revendication 1, dans lequel l'étape d'amincissement, comprend en plus un traitement thermique et/ou mécanique.

**13.** Procédé selon la revendication 12, dans lequel la contrainte de structure obtenue avant amincissement est telle qu'elle participe à la séparation au niveau de la zone de fracture.

**14.** Procédé selon la revendication 1, dans lequel au moins une couche d'adaptation de contraintes est formée par dépôt de matière selon un procédé de dépôt choisi parmi les procédés de pulvérisation, d'épitaxie, de dépôt chimique, tel que le dépôt chimique en phase vapeur, le dépôt en phase vapeur à basse pression, et le dépôt en phase vapeur assisté par plasma.

**15.** Procédé selon la revendications 1, dans lequel au moins une couche d'adaptation de contraintes est obtenue par oxydation superficielle d'une plaque.

**16.** Procédé selon la revendication 1, dans lequel au moins une couche d'adaptation de contraintes est obtenue par implantation d'espèces dans une plaque.

**17.** Procédé selon la revendication 1, dans lequel les plaques sont réalisées en au moins un matériau choisi parmi le silicium, le germanium, le carbure de silicium, les semi-conducteurs de type III-V, les semi-conducteurs de type II-VI, le verre, les supraconducteurs, le diamant, les matériaux céramiques ($LiNbO_3$, $LiTaO_3$), et le quartz, et dans lequel les couches d'adaptation de contraintes sont réalisées en au moins un matériau choisi parmi $SiO_2$, SiN, $Si_3N_4$, TiN, les métaux, les alliages métalliques, et le diamant ou des matériaux d'une des plaques.

**Claims**

**1.** Method for producing a multilayer structure having a determined structure stress and for microelectronics or micromechanics applications, wherein :

a) a first plate (110a, 210a) is provided with a first adaptation layer (130, 220) of the stresses induced in the structure during a heat treatment, and one of a second plate (110b, 210b) and the first adaptation layer (130, 220) is provided with at least a second adaptation layer (120, 230) of the stresses induced in the structure during a heat treatment, the first and second adaptation layers being realized in materials and with thickness such that, at the end of the method, said determined structure stress is obtained in the structure ;
b) an assembly of the first and second plates is performed via the stress adaptation layers ;
c) after step b) a heat treatment with sufficient temperature and duration is performed for adjusting said determined structure stress in the structure ;
d) after the assembly step, a thinning step of one at least of the first and second plates is performed, this thinning step comprising a separation step for fracturing the plate to thin along a fracture area realized before the assembly step, said fracture area being realized by at least an implantation of gas species in at least one of the first and second plates.

2. The method according to claim 1, wherein said assembly of first and second plates comprises an adherence bond.

3. The method according to claim 1 or 2, wherein the first and second adaptation layers are produced in materials and with thicknesses such as the stresses with the first and second plates are of opposite sign, respectively.

4. The method according to claim 1, wherein at least one of the stress adaptation layers is surmounted by at least a so-called intermediate layer.

5. The method according to claim 1 or 2, wherein said assembly comprises a molecular adhesion bond between layers.

6. The method according to claim 5, wherein before step b), a preparation of the layers to be combined by molecular bonding is performed for adjusting their surface condition.

7. The method according to claim 5, wherein during step b), the molecular bonding is performed at room temperature.

8. The method according to claim 1, wherein said assembly comprises a bond implementing at least one bonding technique selected from: brazing, welding, interdiffusion between layers, and bonding with an adhesive substance.

9. The method according to claim 1, wherein said assembly occurs via an adhesion layer.

10. The method according to claim 1, wherein during step a), the first stress adaptation layer (130, 220) is formed on the first plate (110a, 210a) and the second stress adaptation layer (120, 230) is formed on the second plate (110b, 210b), and wherein during step b), molecular bonding is performed between the stress adaptation layers.

11. The method according to claim 1, wherein the first and second stress adaptation layers are formed on the first main layer and the bonding occurs between the second main layer and one of the first and second surface stress adaptation layers.

12. The method according to claim 1, wherein the thinning step further comprises a thermal and/or mechanical treatment.

13. The method according to claim 12, wherein the obtained structure stress before thinning is such that it participates in the separation at the fracture area.

14. The method according to claim 1, wherein at least one stress adaptation layer is formed by depositing material according to a deposition method selected from spray, epitaxy, chemical deposition methods such as chemical vapor deposition, low pressure vapor deposition and plasma-enhanced vapor deposition.

15. The method according to claim 1, wherein at least one stress adaptation layer is obtained by surface oxidization of a plate.

16. The method according to claim 1, wherein at least one stress adaptation layer is obtained by implanting species in a plate.

17. The method according to claim 1, wherein the plates are produced in at least one material selected from silicon, germanium, silicon carbide, III-V type semiconductors, II-VI type semiconductors, glass, supraconductors, diamond, ceramic materials ($LiNbO_3$, $LiTaO_3$), and quartz and wherein the stress adaptation layers are produced in at least one material selected from $SiO_2$, $SiN$, $Si_3N_4$, $TiN$, metals, metal alloys, and diamond or materials from one of the plates.

**Patentansprüche**

1. Verfahren zur Herstellung einer mehrschichtigen Struktur mit einer bestimmten Strukturspannung und bestimmt für Anwendungen in der Mikroelektronik oder Mikromechanik, bei dem:

a) man eine erste Platte (110a, 210a) mit einer ersten Anpassungsschicht (130, 220) der während einer thermischen Behandlung in der Struktur erzeugten Spannungen versieht, und man entweder eine zweite Platte (110b, 210b) oder die erste Anpassungsschicht (130, 220) mit wenigstens einer zweiten Anpassungsschicht (120, 230) der während einer thermischen Behandlung in der Struktur erzeugten Spannungen versieht, wobei die erste und die zweite Anpassungsschicht mit solchen Materialien und Dikken realisiert werden, dass man am Ende des Verfahrens in der Struktur die genannte bestimmte Strukturspannung erhält;
b) man einen Zusammenbau der ersten und der zweiten Platte mit Hilfe der Spannungsanpassungsschichten realisiert;
c) man nach Schritt b) eine thermische Behandlung mit einer Temperatur und Dauer realisiert, die ausreichen, um in der Struktur die genannte bestimmte Strukturspannung anzupassen;

d) man nach dem Zusammenbauschritt einen Schritt zur Dünnung von wenigstens einer der ersten oder zweiten - Platte realisiert, wobei dieser Dünnungsschritt einen Trennungsschritt umfasst, um die zu dünnende Platte gemäß einer vor dem Zusammenbauschritt realisierten Bruchzone auseinanderzubrechen, wobei die genannte Bruchzone durch wenigstens eine Implantation gasförmiger Spezies in wenigstens eine - die erste oder zweite - Platte realisiert wird.

2. Verfahren nach Anspruch 1, bei dem der genannte Zusammenbau der ersten und zweiten Platte eine Adhäsionsklebung umfasst.

3. Verfahren nach Anspruch 1 oder 2, bei dem die erste und zweite Anpassungsschicht mit solchen Materialien und Dicken realisiert werden, dass die Spannungen mit der ersten und zweiten Platte jeweils ein entgegengesetztes Vorzeichen aufweisen.

4. Verfahren nach Anspruch 1, bei dem wenigstens eine der Spannungsanpassungsschichten von wenigstens einer sogenannten Zwischenschicht überlagert wird.

5. Verfahren nach Anspruch 1 oder 2, bei dem der genannte Zusammenbau eine Molekularadhäsionsklebung zwischen Schichten umfasst.

6. Verfahren nach Anspruch 5, bei dem man vor dem Schritt b) die durch Molekularklebung zu verbindenden Schichten vorbereitet, um ihren Oberflächenzustand anzupassen.

7. Verfahren nach Anspruch 5, bei dem die Molekularklebung in Schritt b) bei Umgebungstemperatur realisiert wird.

8. Verfahren nach Anspruch 1, bei dem der genannte Zusammenbau eine Klebung umfasst, bei der wenigstens eine Klebetechnik angewendet wird, die ausgewählt wird unter: Lötung, Schweißung, Interdiffusion zwischen Schichten und Klebung mittels einer Adhäsionssubstanz.

9. Verfahren nach Anspruch 1, bei dem der Zusammenbau mit Hilfe einer Adhäsionsschicht stattfindet.

10. Verfahren nach Anspruch 1, bei dem man in Schritt a) die erste Spannungsanpassungsschicht (130, 220) auf der ersten Platte (110a, 210a) ausbildet und die zweite Spannungsanpassungsschicht (120, 230) auf der zweiten Platte (110b, 210b), und bei dem man in Schritt b) eine Molekularklebung zwischen den Spannungsanpassungsschichten durchführt.

11. Verfahren nach Anspruch 1, bei dem die erste und zweite Spannungsanpassungsschicht auf der ersten Platte ausgebildet werden und die Klebung zwischen der zweiten Platte und einer - der ersten oder zweiten - Oberflächenspannungs-Anpassungsschicht stattfindet.

12. Verfahren nach Anspruch 1, bei dem der Dünnungsschritt zudem eine thermische und/oder mechanische Behandlung umfasst.

13. Verfahren nach Anspruch 12, bei dem die vor der Dünnung erhaltene Strukturspannung derartig ist, dass sie an der Trennung in Höhe der Bruchzone beteiligt ist.

14. Verfahren nach Anspruch 1, bei dem wenigstens eine Spannungsanpassungsschicht durch Materialabscheidung gemäß einem Abscheidungsverfahren ausgebildet wird, das ausgewählt wird unter den Verfahren: Sputtern, Epitaxie, chemische Abscheidung wie etwa CVD, LPCVD und PECVD.

15. Verfahren nach Anspruch 1, bei dem wenigstens eine Spannungsanpassungsschicht durch Oberflächenoxidierung einer Platte erzeugt wird.

16. Verfahren nach Anspruch 1, bei dem wenigstens eine Spannungsanpassungsschicht durch Implantierung von Spezies in eine Platte erzeugt wird.

17. Verfahren nach Anspruch 1, bei dem die Platten aus wenigstens einem unter Silicium, Germanium, Siliciumkarbid, Halbleitern des Typs III-V, Halbleitern des Typs II-VI, Glas, Supraleitern, Diamant, keramischen Materialien ($LiNbO_3$, $LiTaO_3$) und Quarz ausgewählten Material realisiert werden, und bei dem die Spannungsanpassungsschichten aus wenigstens einem unter $SiO_2$, $SiN$, $Si_3N_4$, $TiN$, Metallen, Metalllegierungen und Diamant oder den Materialien von einer der Platten ausgewählten Material realisiert werden.

FIG. 1

10b

20a

10a

FIG. 2

10b

20a

10a

FIG. 3

10b

20a

10a

FIG. 4

10b

20a

10a

FIG. 5

FIG. 6

FIG. 7

FIG. 8

FIG. 9

FIG. 10

Flèche

**FIG. 11**

220
210a

**FIG. 12**

220
212
214
210a

**FIG. 13**

230
210b

**FIG. 14**

210a
212
214
220
230
210b

**FIG. 15**

210a
214
220
230
210b

FIG. 16

240
214
220
225
230
210b

FIG. 17

245 244 242 240
214
225
210b

FIG. 18

240 244 242 245
214
225
210b

FIG. 19

240    242    244    242    245
214
225
210b

FIG. 20

244    240
246    248
214
225
210b

## RÉFÉRENCES CITÉES DANS LA DESCRIPTION

**Documents brevets cités dans la description**

- JP 06013593 A
- EP 0410679 A
- US 5362667 A
- FR 2681472 A

**Littérature non-brevet citée dans la description**

- *Patent Abstracts of Japan,* 15 Avril 1994, vol. 18 (213
- **BOWER et al.** *Appl. Phys. Lett.,* 1993, vol. 62 (26), 3485
- **M. TAMURA et al.** *Jpa. J. Appl. Phys.,* Août 1972, vol. 11 (8), 1097
- **H. MIKOSHIBA.** *J. Electrochem. Soc.,* Octobre 1976, vol. 123 (10), 1539
- **S. SANCHEZ et al.** *J. Michromech. Microeng.,* 1997, vol. 7, 111-113
- **HARENDT et al.** *Sensors and Actuators A,* 1991, vol. 25-27, 87-92
- **C. GUI ; M. ELWENSPOEK ; J.G.E. GARDENEIERS ; P.V. LAMBECK.** *E.C.S.,* 1997, vol. 97-36, 114